# EUROPEAN PATENT SPECIFICATION

(11) **EP 3 376 321 B1**
(45) Date of publication and mention of the grant of the patent: **15.04.2020**
(21) Application number: 17207728.1
(22) Date of filing: 15.12.2017
(51) Int. Cl.: H02M 1/00, G05B 19/4065, H02M 3/157

(54) **POWER-SUPPLY DEVICE**
STROMVERSORGUNGSVORRICHTUNG
DISPOSITIF D'ALIMENTATION ÉLECTRIQUE

(30) Priority: 13.03.2017 JP 2017047400
(43) Date of publication of application: 19.09.2018
(73) Proprietor: OMRON CORPORATION, Kyoto-shi, Kyoto 600-8530 (JP)
(72) Inventor: NAGANO, Masaaki, Kyoto-shi, Kyoto 600-8530 (JP); NIWA, Hiroki, Kyoto-shi, Kyoto 600-8530 (JP); TANINO, Kohei, Kyoto-shi, Kyoto 600-8530 (JP); YAMAMOTO, Michihiro, Kyoto-shi, Kyoto 600-8530 (JP); SHIMIZU, Masato, Kyoto-shi, Kyoto 600-8530 (JP); OKADA, Kei, Kyoto-shi, Kyoto 600-8530 (JP)
(74) Representative: Becker & Kurig Partnerschaft Patentanwälte PartmbB

(56) References cited:
- GB-A- 2 430 039
- JP-A- 2001 091 413
- US-A1- 2012 136 587

## Description

### BACKGROUND

### Technical Field

The present invention relates to a power-supply device capable of displaying information about a lifespan.

### Description of Related Art

Power-supply devices include devices for displaying an accumulated operation time and devices for displaying a remaining lifespan time as a function of indicating a lifespan that is a replacement period. A user needs to decide whether to select the power-supply device for displaying the accumulated operation time to indicate the lifespan or the power-supply device for displaying the remaining lifespan time to indicate the lifespan according to the purpose at the time of purchase. For example, in the device for displaying the remaining lifespan time to indicate the lifespan, the remaining lifespan time that decreases with the sequential passage of time is stored in a memory for the remaining lifespan time, and the remaining lifespan time that is displayed is calculated by subtracting an elapsed time of the lifespan, which also includes calculations of a temperature detected by a temperature sensor, from the remaining lifespan time (Patent Document 1).

### Patent Documents

[Patent Document 1] Japanese Unexamined Patent Application Publication No. 2001-91413

### SUMMARY

However, in the device disclosed in Patent Document 1, a user can obtain no information about the lifespan of the device other than the remaining lifespan time, and cannot obtain the accumulated operation time. If the user buys the device and selects the device for displaying the accumulated operation time, although the user may later want to display the remaining lifespan time, there is no method other than to replace the device. Further, there is a problem that the user cannot know to what degree of the lifespan the device has been operated when only the accumulated operation time or the remaining lifespan time is displayed.

The present invention is directed to provide a power-supply device in which a difference between a time that the device has been operated and an actual estimate of the remaining lifespan time can be understood.

According to any aspect of the present invention, a power-supply device includes: a power-supply section; a timing part configured to check an operation time of the power-supply section; a computing part configured to accumulate the operation time checked by the timing part to calculate an accumulated operation time, and to compute a remaining lifespan time based on information from the power-supply section; and a display section configured to display information about the lifespan of the power-supply section. The display section enables display of the accumulated operation time and the remaining lifespan time as the information about the lifespan of the power-supply section.

The power-supply device further includes an input part configured to input a switching signal for switching the information displayed by the display section. The display section switches display between the accumulated operation time and the remaining lifespan time based on the switching signal input to the input part as the information about the lifespan of the power-supply section.

The power-supply device further includes a communication part configured to perform communication with an external device. The input part inputs a received signal of the communication part as the switching signal. Preferably, the input part is a display switching switch.

Preferably, the communication part enables transmission of the accumulated operation time and the remaining lifespan time to the external device as the information about the lifespan of the power-supply section.

Preferably, the computing part computes a remaining ratio of the lifespan based on the accumulated operation time and the remaining lifespan time, and the display section displays the remaining ratio of the lifespan computed by the computing part.

According to the power-supply device relating to the present technique, since an accumulated operation time and a remaining lifespan time can be displayed by a display section as information about a lifespan of a power-supply section, a difference between a time that the device has been operated and an actual estimate of the remaining lifespan time can be understood and used as reference for improving the device.

### BRIEF DESCRIPTION OF THE DRAWINGS

FIG. 1 is a block diagram for describing a configuration of a power-supply device according to an embodiment of the present invention.
FIG. 2 is a view schematically illustrating an example of an exterior of the power-supply device according to the embodiment of the present invention.
FIG. 3(a) and FIG. 3(b) are a view illustrating an accumulated operation time displayed by the power-supply device according to the embodiment of the present invention and an example of display thereof.
FIG. 4(a) and FIG. 4(b) are a view illustrating a remaining lifespan time displayed by the power-supply device according to the embodiment of the present invention and an example of display thereof.
FIG. 5 is a view illustrating an example of display of a remaining ratio of a lifespan displayed by the power-supply device according to the embodiment of the present invention.
FIG. 6 is a flow chart for describing a process of displaying information about a lifespan with the power-supply device according to the embodiment of the present invention.

### DESCRIPTION OF THE EMBODIMENTS

Hereinafter, the present embodiment will be described in detail with reference to the drawings. In the drawings, the same reference sign indicates an identical or equivalent part.

### (A. Configuration of power-supply device)

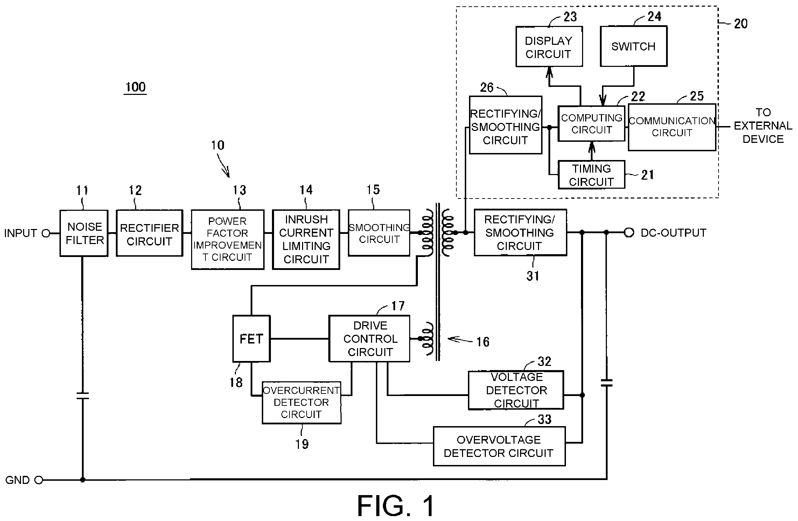

A configuration of a power-supply device according to an embodiment of the present invention will be described using the drawings. FIG. 1 is a block diagram for describing a configuration of a power-supply device according to an embodiment of the present invention. A power-supply device 100 illustrated in FIG. 1 is a switching power-supply device, and includes a power-supply section 10 and a display section 20.

The power-supply section 10 includes a noise filter 11, a rectifier circuit 12, a power factor improvement circuit 13, an inrush current limiting circuit 14, a smoothing circuit 15, a transformer 16, a drive control circuit 17, a MOSFET 18, an overcurrent detector circuit 19, a rectifying/smoothing circuit 31, a voltage detector circuit 32, and an overvoltage detector circuit 33.

When an AC power supply (e.g., a commercial power supply of 100/200 V at 50/60 Hz) is connected to an INPUT, the noise filter 11 performs filtering on a high-frequency noise component superimposed on AC power, and supplies the AC power from which the noise component is removed to the rectifier circuit 12.

The rectifier circuit 12 is composed of a full-wave rectifier circuit of a diode bridge, and generates DC power of a primary side as a pulsating flow obtained by full-wave rectifying the AC power supplied from the noise filter 11.

The power factor improvement circuit 13 is a circuit for inhibiting a high-frequency current generated at an input current, and is also called a power factor correction (PFC) circuit. The inrush current limiting circuit 14 is made up of, for instance, a resistor and a relay inserted with this resistor in parallel, and is configured to be able to prevent an inrush current when the relay is opened for tens of milliseconds from activation, and then activate power start when the relay is closed. The smoothing circuit 15 is composed of a smoothing capacitor, and smooths the full-wave rectified AC power.

The drive control circuit 17 is composed of a control IC having a pulse width modulation (PWM) signal generator, a feedback control circuit, an overcurrent protect (OCP) terminal, a switching drive terminal, a drive power terminal, and so on, supplies a high-frequency PWM signal to a gate of the MOSFET 18, and drives the MOSFET 18.

The drive control circuit 17 feeds back a voltage of a secondary side (an output side), which is detected by the voltage detector circuit 32, via a photo coupler (not shown). The drive control circuit 17 changes a duty ratio of the PWM signal on the basis of the voltage, and drives the MOSFET 18 to make an output voltage of the DC power become a specified value. Further, the overcurrent detector circuit 19 is provided between the drive control circuit 17 and the MOSFET 18.

The MOSFET 18 is connected to a primary winding of the transformer 16 in series, intermittently connects the primary-side DC power in response to the PWM signal supplied from the drive control circuit 17, and generates high-frequency pulse power (AC power) at the primary winding.

The transformer 16 is composed of an insulated transformer in which a primary side and a secondary side are electrically insulated, includes a primary winding, a secondary winding, and an auxiliary winding, and induces the high-frequency pulse power (the AC power) generated at the primary winding in the secondary winding and the auxiliary winding. The high-frequency pulse power (the AC power) induced in the secondary winding is used for DC output power, and the high-frequency pulse power (the AC power) induced in the auxiliary winding is used to activate the drive control circuit 17.

The rectifying/smoothing circuit 31 is made up of a half-wave rectifier circuit of a diode, and a smoothing capacitor, smooths the high-frequency pulse power (the AC power) induced in the secondary winding after the high-frequency pulse power (the AC power) is half-wave rectified, and generates DC output power of a specified output voltage and current. The generated DC output power is output from DC-OUTPUT.

The voltage detector circuit 32 detects the output voltage of the DC output power using a corresponding drop voltage, and outputs it to the drive control circuit 17 via a photo coupler (not shown). The overvoltage detector circuit 33 is provided between an output side of the DC output power and the drive control circuit 17 via the photo coupler (not shown).

The display section 20 includes a timing circuit 21, a computing circuit 22, a display circuit 23, a switch 24, a communication circuit 25, and a rectifying/smoothing circuit 26.

The timing circuit 21 is a timer for checking an operation time of the power-supply section 10. The timing circuit 21 checks a time for which the DC output power is generated from the DC-OUTPUT, and does not check a non- operation time.

The computing circuit 22 is a circuit that accumulates the time checked by the timing circuit 21 to calculate the accumulated operation time or computes a remaining lifespan time and a remaining ratio of the lifespan. Further, the computing circuit 22 performs display control of the display circuit 23, reception of a switching signal input from the switch 24, control of the communication circuit 25, and so on. The computing circuit 22 is made up of a central processing unit (CPU) as a control center, a read only memory (ROM) in which a program for operating the CPU or control data is stored, a random access memory (RAM) that functions as a work area of the CPU, an input/output interface for maintaining consistency of a signal with a peripheral, and so on.

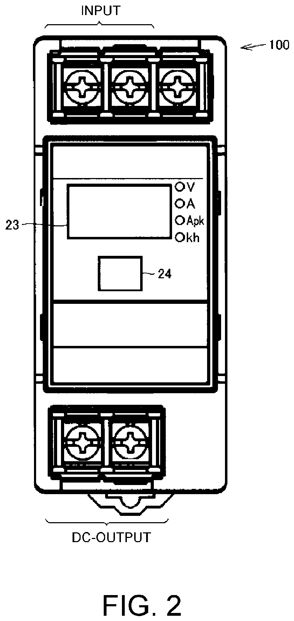

The display circuit 23 is a display device provided on a surface of the power-supply device 100. FIG. 2 is a view schematically illustrating an example of an exterior of the power-supply device according to the embodiment of the present invention. In the power-supply device 100 illustrated in FIG. 2, the display circuit 23 and the switch 24 are provided on planes on which a terminal of the INPUT and a terminal of the DC-OUTPUT are provided. The display circuit 23 is for instance a 3-digit 7-segment display, and indicates a content of a value displayed by turning on LED lamps lined up at a lateral side of the display circuit 23. For example, when an LED lamp of "V" is turned on, a value displayed on the display circuit 23 represents a voltage which the power-supply device 100 outputs. When an LED lamp of "kh" is turned on, a value displayed on the display circuit 23 represents information about the lifespan of the power-supply device 100. The display circuit 23 may be an LCD or an organic EL display.

The switch 24 is a display switching switch, and switches the content displayed by the display circuit 23. A user pushes the switch 24 down, and thereby a switching signal is input to the computing circuit 22. The computing circuit 22 controls the display of the display circuit 23 to switch and display an accumulated operation time and a remaining lifespan time as information about the lifespan of the power-supply section 10 based on the input switching signal.

The communication circuit 25 is a circuit for performing communication with an external device, and can use well-known means such as Universal Serial Bus (USB) communication, serial communication, parallel communication, a wired network (e.g., Ethernet (registered trademark)), a wireless network (e.g., wireless LAN or BLUETOOTH (registered trademark)), or the like. A switching signal for switching the displayed content of the display circuit 23 can be input from the external device via the communication circuit 25, or the accumulated operation time and the remaining lifespan time acting as the information about the lifespan of the power-supply section 10 can be output from the computing circuit 22 to the external device.

The rectifying/smoothing circuit 26 is made up of a half-wave rectifier circuit of a diode and a smoothing capacitor, smooths the high-frequency pulse power (the AC power) induced in the secondary winding after the high-frequency pulse power (the AC power) is half-wave rectified, and generates DC output power of specified output voltage and current. The generated DC output power is used to activate the display section 20.

### (B. Accumulated operation time)

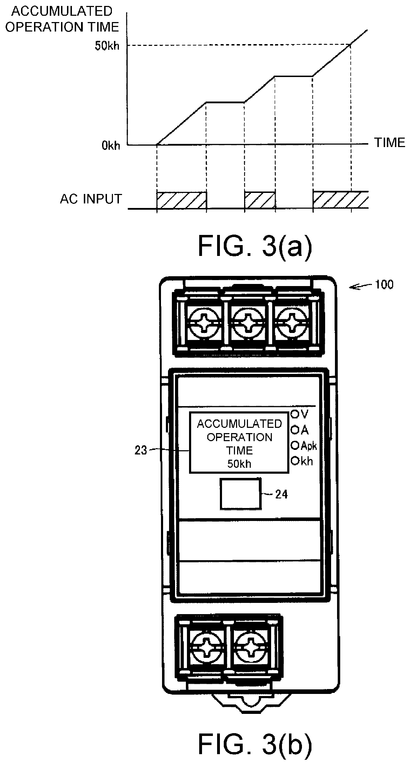

The computing circuit 22 accumulates the time checked by the timing circuit 21 to calculate an accumulated operation time, and computes the information about the lifespan of the power-supply section 10. FIG. 3(a) and FIG. 3(b) are a view illustrating an accumulated operation time displayed by the power-supply device according to the embodiment of the present invention and an example of display thereof. FIG. 3(a) represents a relation between a time and an accumulated operation time. The accumulated operation time is added to only in a period in which AC input is present in the power-supply section 10, and the accumulated operation time is not added to in a period in which no AC input is present.

That is, the computing circuit 22 accumulates the accumulated operation time only for a time for which the DC output power is generated at the power-supply section 10, and thereby can calculate the accumulated operation time. The accumulated operation time is obtained by accumulating the time for which the DC output power is generated, and an influence or the like of an amount of deterioration or an ambient temperature of an electrolytic capacitor mounted in a power supply is not considered.

When the accumulated operation time is 50 kh, the computing circuit 22 controls the display circuit 23 such that "accumulated operation time" and "50kh" are displayed on the display circuit 23 (FIG. 3(b)). Hereinafter, the display circuit 23 will be described as an LCD. That is, when a user wants to display the accumulated operation time as the information about the lifespan of the power-supply section 10, the user pushes the switch 24 down, and switches the displayed content of the display circuit 23 to the accumulated operation time, and thereby can obtain the display of FIG. 3(b).

### (C. Remaining lifespan time)

The computing circuit 22 calculates the remaining lifespan time based on the amount of deterioration or the ambient temperature of the electrolytic capacitor, and computes information about the lifespan of the power-supply section 10. In the electrolytic capacitor used in the smoothing circuit 15 or the like of the power-supply device 100, from the time of production, an impregnated electrolyte penetrates a sealing rubber, vaporization of the internal electrolyte advances over time, and deterioration of characteristics including a reduction in capacitance occurs. A lifespan of the electrolytic capacitor is greatly dependent on the lifespan of the power-supply section 10. Accordingly, the computing circuit 22 calculates the remaining lifespan time of the power-supply section 10 on the basis of the amount of deterioration of the electrolytic capacitor which is the information from the power-supply section 10.

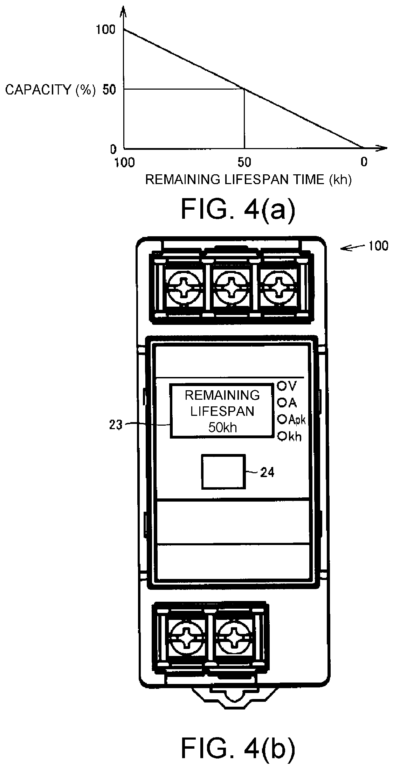

FIG. 4(a) and FIG. 4(b) are a view illustrating a remaining lifespan time displayed by the power-supply device according to the embodiment of the present invention and an example of display thereof. FIG. 4(a) is a graph illustrating a relation between a capacity of the electrolytic capacitor and the remaining lifespan time of the power-supply section 10. The longitudinal axis of FIG. 4(a) indicates the capacity of the electrolytic capacitor when a capacity of the electrolytic capacitor at the time of replacement is set to 0%, and a capacity at the time of production is set to 100%. That is, a reduction in the capacity of the electrolytic capacitor indicates the amount of deterioration of the electrolytic capacitor. The transverse axis of FIG. 4(a) indicates the remaining lifespan time of the power-supply section 10. When the capacity of the electrolytic capacitor is 100%, the remaining lifespan time of the power-supply section 10 is set to 100 kh. When the capacity of the electrolytic capacitor is 0%, the remaining lifespan time of the power-supply section 10 is set to 0 kh.

When the capacity of the electrolytic capacitor is 50%, the computing circuit 22 calculates the remaining lifespan time of the power-supply section 10 at 50 kh as illustrated in FIG. 4(a). For this reason, the computing circuit 22 controls the display circuit 23 such that "remaining lifespan time" and "50 kh" are displayed on the display circuit 23 (FIG. 4(b)). That is, when a user wants to display the remaining lifespan time as the information about the lifespan of the power-supply section 10, the user pushes the switch 24 down, and switches the displayed content of the display circuit 23 to the remaining lifespan time, and thereby can obtain display of FIG. 4(b).

The amount of deterioration of the electrolytic capacitor is greatly changed by the ambient temperature. In general, it is known that the amount of deterioration of the electrolytic capacitor approximately doubles when the ambient temperature is changed by about 10°C according to the chemical reaction kinetics of Arrhenius. When the graph illustrated in FIG. 4(a) is an ambient temperature of 40°C, if the ambient temperature is higher than 40°C, a slope (an absolute value) of the graph increases. In contrast, if the ambient temperature is lower than 40°C, the slope (the absolute value) of the graph decreases. For this reason, the computing circuit 22 may be configured to monitor a temperature inside the power supply during operation using a temperature sensor (not shown), and to calculate the amount of deterioration of the electrolytic capacitor from an operation time and an internal temperature.

Further, the amount of deterioration of the electrolytic capacitor is changed by an input voltage of the power-supply section 10 and a magnitude of a load connected to the power-supply section 10. For this reason, the computing circuit 22 may be configured to monitor an input voltage during operation or the load, and to calculate the amount of deterioration of the electrolytic capacitor from operation times and monitoring amounts thereof.

### (D. Remaining ratio of lifespan)

The accumulated operation time indicates a time for which the power-supply section 10 has been operated, and the remaining lifespan time indicates a time for which the power-supply section 10 can be operated thereafter. However, referring to either of the times, it cannot be known to what degree of the lifespan the power-supply section 10 has been operated. Further, in the power-supply device in which only information of one of the accumulated operation time and the remaining lifespan time is obtained, the user himself/herself cannot switch the display to find out to what degree of the lifespan the power-supply section 10 has been operated.

Therefore, the computing circuit 22 combines the calculated accumulated operation time and the calculated remaining lifespan time, and thereby can indicate a remaining ratio of the lifespan. To be specific, the computing circuit 22 calculates the remaining ratio of the lifespan as [Remaining lifespan time/(Remaining lifespan time + Accumulated operation time)×100](%).

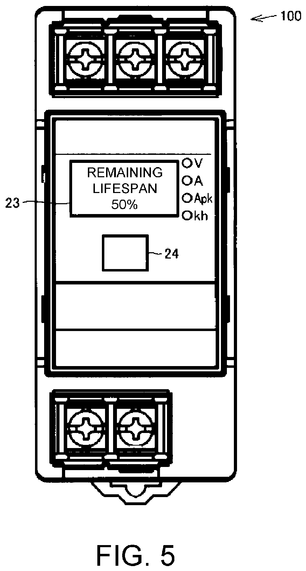

FIG. 5 is a view illustrating an example of display of a remaining ratio of a lifespan displayed by the power-supply device according to the embodiment of the present invention and an example of display thereof. For example, when the accumulated operation time is 50 kh as in FIG. 3(b) and the remaining lifespan time is 50 kh as in FIG. 4(b), the computing circuit 22 calculates the remaining ratio of the lifespan as 50/(50+50)×100=50%. For this reason, the computing circuit 22 controls the display circuit 23 such that "remaining ratio of lifespan" and "50%" are displayed on the display circuit 23 (FIG. 5). That is, when the user wants to display the remaining ratio of the lifespan as the information about the lifespan of the power-supply section 10, the user pushes the switch 24 down and switches the displayed content of the display circuit 23 to the remaining ratio of the lifespan, and thereby can obtain the display of FIG. 5.

The remaining ratio of the lifespan is displayed on the display circuit 23, and thereby the user can know a time for which the device has been operated and a time for which it can be operated thereafter, and know to what degree of the lifespan the power-supply section 10 has been operated. Thereby, a difference between the time for which it has been operated and an actual estimate of the remaining lifespan time can be understood and used as a reference for improving the device.

### (E. Switching information about lifespan of power-supply section 10)

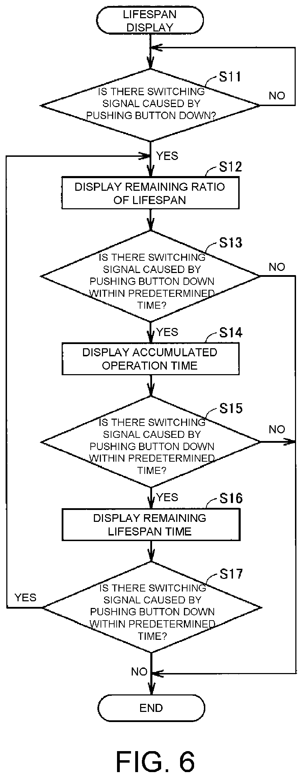

The information about the lifespan of the power-supply section 10 can be switched by pushing the switch 24 illustrated in FIG. 2 down, and be displayed on the display circuit 23. Hereinafter, a process in which the computing circuit 22 switches the information about the lifespan of the power-supply section 10 on the basis of the switching signal input by pushing the switch 24 down and the switching signal received from the external device by the communication circuit 25 will be described. FIG. 6 is a flow chart for describing a process of displaying information about a lifespan with the power-supply device according to the embodiment of the present invention.

First, the computing circuit 22 determines whether the switching signal is input by pushing the switch 24 down or is received by the communication circuit 25 (step S11). When it is determined that the switching signal is input or received (YES in step S11), the computing circuit 22 displays the calculated remaining ratio of the lifespan (FIG. 5) on the display circuit 23 (step S12). When it is determined that the switching signal is not input or received (NO in step S11), the computing circuit 22 enters a waiting state for the input or the reception of the switching signal. That is, when the switching signal is input without the information about the lifespan of the power-supply section 10 displayed on the display circuit 23, the input or the like is triggered to display the information about the lifespan of the power-supply section 10 on the display circuit 23.

Next, the computing circuit 22 determines whether the switching signal is input by pushing the switch 24 down or is received by the communication circuit 25 within a predetermined time (step S13). When it is determined that the switching signal is input or received within a predetermined time (YES in step S13), the computing circuit 22 displays the calculated accumulated operation time (FIG. 3(b)) on the display circuit 23 (step S14). When it is determined that the switching signal is not input or received within a predetermined time (NO in step S13), the computing circuit 22 completes the display of the information about the lifespan of the power-supply section 10. That is, once the information about the lifespan of the power-supply section 10 is temporarily displayed by the input or the like of the switching signal in step S11, if there is an input or the like of the switching signal, the information about the lifespan of the power-supply section 10 is switched.

Next, the computing circuit 22 determines whether the switching signal is input by pushing the switch 24 down or is received by the communication circuit 25 within a predetermined time (step S15). When it is determined that the switching signal is input or received within a predetermined time (YES in step S15), the computing circuit 22 displays the calculated remaining lifespan time (FIG. 4(b)) on the display circuit 23 (step S16). When it is determined that the switching signal is not input or received within a predetermined time (NO in step S15), the computing circuit 22 completes the display of the information about the lifespan of the power-supply section 10.

Next, the computing circuit 22 determines whether the switching signal is input by pushing the switch 24 down or is received by the communication circuit 25 within a predetermined time (step S17). When it is determined that the switching signal is input or received within a predetermined time (YES in step S17), the process returns to step 12, and the computing circuit 22 displays the calculated remaining ratio of the lifespan (FIG. 5) on the display circuit 23. When it is determined that the switching signal is not input or received within a predetermined time (NO in step S17), the computing circuit 22 completes the display of the information about the lifespan of the power-supply section 10. That is, once the information about the lifespan of the power-supply section 10 is temporarily displayed by the input or the like of the switching signal in step S11, the display can be switched in the order of the remaining ratio of the lifespan, the accumulated operation time, and the remaining lifespan time by the input or the like of the switching signal.

As described above, the power-supply device 100 according to the embodiment of the present invention includes the power-supply section 10, the timing circuit 21, the computing circuit 22, and the display circuit 23. The display circuit 23 can display the accumulated operation time and the remaining lifespan time as the information about the lifespan of the power-supply section 10. For this reason, according to the power-supply device 100, the difference between the time for which the device has been operated and an estimate of the actual remaining lifespan time can be understood and used as a reference for improving the device.

### (Modification)

The display circuit 23 has been described as switching display of the remaining ratio of the lifespan, the accumulated operation time, and the remaining lifespan time in that order. However, without being limited thereto, the remaining ratio of the lifespan, the accumulated operation time, and the remaining lifespan time may be displayed on the same display circuit 23.

The display circuit 23 has been described as switching display in the order of the remaining ratio of the lifespan, the accumulated operation time, and the remaining lifespan time with the input or the like of the switching signal within a predetermined time. However, without being limited thereto, the display circuit 23 may automatically switch the display in the order of the remaining ratio of the lifespan, the accumulated operation time, and the remaining lifespan time even without the input or the like of the switching signal within a predetermined time.

The switch 24 functions as operating means for displaying the information about the lifespan of the power-supply section 10 on the display circuit 23 or switching the display. However, a function of another operation (e.g., displaying a voltage value) may be assigned.

### [Explanation of sign]

10: power-supply section, 11: noise filter, 12: rectifier circuit, 13: power factor improvement circuit, 14: inrush current limiting circuit, 15: smoothing circuit, 16: transformer, 17: drive control circuit, 18: MOSFET, 19: overcurrent detector circuit, 20: display section, 21: timing circuit, 22: computing circuit, 23: display circuit, 24: switch, 25: communication circuit, 26, 31: rectifying/smoothing circuit, 32: voltage detector circuit, 33: overvoltage detector circuit, 100: power-supply device

## Claims

1. A power-supply device (100) comprising:
a power-supply section (10);
a timing part (21) configured to check an operation time of the power-supply section (10);
a computing part (22) configured to accumulate the operation time checked by the timing part (21) to calculate an accumulated operation time, and to compute a remaining lifespan time based on information from the power-supply section (10); and
a display section (23) configured to display information about a lifespan of the power-supply section (10),
wherein the display section (23) is configured to enable display of the accumulated operation time and the remaining lifespan time as the information about the lifespan of the power-supply section (10),
the power-supply device (100) being **characterized in** further comprising:
an input part configured to input a switching signal for switching the information displayed by the display section (23); and
communication part (25) configured to perform communication with an external device,
wherein the display section (23) is configured to switch display between the accumulated operation time and the remaining lifespan time based on the switching signal input to the input part as the information about the lifespan of the power-supply section (10),
wherein the input part is configured to input a received signal of the communication part (25) as the switching signal.

2. The power-supply device (100) according to claim 1, wherein the input part is a display switching switch (24).

3. The power-supply device (100) according to claim 1, wherein the communication part (25) is configured to enable transmission of the accumulated operation time and the remaining lifespan time to the external device as the information about the lifespan of the power-supply section (10).

4. The power-supply device (100) according to any one of claims 1 to 3, wherein the computing part (22) is configured to compute a remaining ratio of the lifespan based on the accumulated operation time and the remaining lifespan time, and the display section (23) is configured to display the remaining ratio of the lifespan computed by the computing part (22).

## Patentansprüche

1. Stromversorgungsvorrichtung (100), umfassend:
einen Stromversorgungsabschnitt (10);
ein Zeitsteuerungsteil (21), das konfiguriert ist, um eine Betriebszeit des Stromversorgungsabschnitts (10) zu überprüfen;
ein Kalkulationsteil (22), das konfiguriert ist, um die Betriebszeit zu akkumulieren, überprüft durch den Zeitsteuerungsteil (21), um eine akkumulierte Betriebszeit zu berechnen und eine verbleibende Lebensdauerzeit basierend auf Informationen von dem Stromversorgungsabschnitt (10) zu kalkulieren; und
einen Anzeigeabschnitt (23), der konfiguriert ist, um Informationen über eine Lebensdauer des Stromversorgungsabschnitts (10) anzuzeigen,
wobei der Anzeigeabschnitt (23) konfiguriert ist, die Anzeige der akkumulierten Betriebszeit und der verbleibenden Lebensdauerzeit als die Informationen über die Lebensdauer des Stromversorgungsabschnitts (10) zu ermöglichen,
wobei die Stromversorgungsvorrichtung (100) **dadurch gekennzeichnet ist, dass** sie ferner umfasst:
ein Eingangsteil, das konfiguriert ist, um ein Schaltsignal zum Schalten der Informationen einzugeben, die von dem Anzeigeabschnitt (23) angezeigt wird; und
ein Kommunikationsteil (25), das konfiguriert ist, um Kommunikation mit einer externen Vorrichtung durchzuführen,
wobei der Anzeigeabschnitt (23) konfiguriert ist, um die Anzeige zwischen der akkumulierten Betriebszeit und der verbleibenden Lebensdauerzeit basierend auf dem Schaltsignal, eingegeben in den Eingangsteil als die Informationen über die Lebensdauer des Stromversorgungsabschnitts (10) umzuschalten,
wobei das Eingangsteil konfiguriert ist, um ein empfangenes Signal des Kommunikationsteils (25) als das Schaltsignal einzugeben.

2. Stromversorgungsvorrichtung (100) gemäß Anspruch 1, wobei das Eingangsteil ein Anzeigeschaltungsschalter (24) ist.

3. Stromversorgungsvorrichtung (100) gemäß Anspruch 1, wobei das Kommunikationsteil (25) konfiguriert ist, um die Übertragung der akkumulierten Betriebszeit und der verbleibenden Lebensdauerzeit an die externe Vorrichtung als die Informationen über die Lebensdauer des Stromversorgungsabschnitts (10) zu ermöglichen.

4. Stromversorgungsvorrichtung (100) gemäß irgendeinem der Ansprüche 1 bis 3, wobei das Kalkulationsteil (22) konfiguriert ist, um ein Restverhältnis der Lebensdauer basierend auf der akkumulierten Betriebszeit und der verbleibenden Lebensdauerzeit zu kalkulieren und der Anzeigeabschnitt (23) konfiguriert ist, um das Restverhältnis der Lebensdauer anzuzeigen, kalkuliert durch das Kalkulationsteil (22).

## Revendications

1. Dispositif d'alimentation électrique (100) comprenant :
une section d'alimentation électrique (10) ;
une partie de temporisation (21) configurée pour vérifier une durée de fonctionnement de la section d'alimentation électrique (10) ;
une partie informatique (22) configurée pour accumuler la durée de fonctionnement vérifiée par la partie de temporisation (21) pour calculer une durée de fonctionnement accumulée, et calculer informatiquement une durée de vie restante sur la base d'une information provenant de la section d'alimentation électrique (10) ; et
une section d'affichage (23) configurée pour afficher une information relative à une durée de vie de la section d'alimentation électrique (10),
dans lequel la section d'affichage (23) est configurée pour permettre l'affichage de la durée de fonctionnement accumulée et la durée de vie restante en tant que l'information relative à la durée de vie de la section d'alimentation électrique (10),
le dispositif d'alimentation électrique (100) étant **caractérisé en ce qu'**il comprend en outre :
une partie d'entrée configurée pour entrer un signal de commutation pour commuter l'information affichée par la section d'affichage (23) ; et
une partie de communication (25) configurée pour effectuer une communication avec un dispositif externe,
dans lequel la section d'affichage (23) est configurer l'affichage entre la durée de fonctionnement accumulée et la durée de vie restante sur la base du signal de commutation entrée dans la partie d'entrée en tant que l'information relative à la durée de vie de la section d'alimentation électrique (10),
dans lequel la partie d'entrée est configurée pour entrer un signal reçu de la partie de communication (25) en tant que le signal de commutation.

2. Dispositif d'alimentation électrique (100) selon la revendication 1, dans lequel la partie d'entrée est un commutateur de commutation d'affichage (24).

3. Dispositif d'alimentation électrique (100) selon la revendication 1, dans lequel la partie de communication (25) est configurée pour permettre une transmission de la durée de fonctionnement accumulée et de la durée de vie restante du dispositif externe en tant que l'information relative à la durée de vie de la section d'alimentation électrique (10).

4. Dispositif d'alimentation électrique (100) selon une quelconque des revendications 1 à 3, dans lequel la partie informatique (22) est configurée pour calculer informatiquement un rapport restant de la durée de vue sur la base de la durée de fonctionnement accumulée et de la durée de vie restante, et la section d'affichage (23) est configurée pour afficher le rapport restant de la durée de vie calculée informatiquement par la partie informatique (22).
